# EUROPEAN PATENT SPECIFICATION

(11) **EP 4 569 547 B1**
(45) Date of publication and mention of the grant of the patent: **11.03.2026**
(21) Application number: 23749109.7
(22) Date of filing: 03.08.2023
(51) Int. Cl.: H10H 20/851

(54) **LED'S WITH IMPROVED EFFICIENCY AND FILLED SPECTRAL POWER DISTRIBUTION**
LEDS MIT VERBESSERTEM WIRKUNGSGRAD UND GEFÜLLTER SPEKTRALER LEISTUNGSVERTEILUNG
DEL DOTÉES D'UNE EFFICACITÉ ACCRUE ET D'UNE MEILLEURE DISTRIBUTION DE PUISSANCE SPECTRALE REMPLIE

(30) Priority: 09.08.2022 EP 22189365
(43) Date of publication of application: 18.06.2025
(73) Proprietor: Signify Holding B.V., 5656 AE Eindhoven (NL)
(72) Inventor: PEETERS, Martinus, Petrus, Joseph, 5656 AE Eindhoven (NL); VAN DER LUBBE, Marcellus, Jacobus, Johannes, 5656 AE Eindhoven (NL); WEGH, René, Theodorus, 5656 AE Eindhoven (NL); HOELEN, Christoph, Gerard, August, 5656 AE Eindhoven (NL)
(74) Representative: Verweij, Petronella Daniëlle
(86) International application number: PCT/EP2023/071554
(87) International publication number: WO 2024/033217

(56) References cited:
- EP-B1- 3 364 470
- US-A1- 2011 220 920
- US-A1- 2016 372 638

## Description

### FIELD OF THE INVENTION

The invention relates to a light generating system as well as to a lighting device comprising such light generating system.

### BACKGROUND OF THE INVENTION

Full spectrum white light emitting devices are known in the art. WO2021/007123, for instance, describes a full spectrum white light emitting device comprising: a broadband solid-state excitation source for generating broadband excitation light with a dominant wavelength from about 420 nm to about 480 nm and a FWHM intensity of at least 25 nm; and a narrowband red photoluminescence material with an emission peak wavelength from about 620nm to about 640 nm and a FWHM intensity of less than about 30 nm; wherein the device has an efficacy of at least 130 lm/W and generates white light with a CRI Ra 90, and wherein over a wavelength range from about 430 nm to about 520 nm, a maximum percentage intensity deviation of said white light from the intensity of light of a black-body curve or CIE Standard Illuminant D is less than about 50%.

US2016/372638A discloses a semiconductor light emitting device that includes an LED and an associated recipient luminophoric medium that includes respective first through fourth luminescent materials that down-convert respective first through fourth portions of the radiation emitted by the LED to radiation having respective first through fourth peak wavelengths. The first peak wavelength is in the green color range and the second through fourth peak wavelengths are in the red color range. The second and third luminescent materials each emit light having a full-width half maximum bandwidth of at least 70 nanometers, while the fourth luminescent material emits light having a full-width half maximum bandwidth of less than 60 nanometers.

### SUMMARY OF THE INVENTION

In the art, a number of white light emitting lighting devices are proposed. In view of aspects like energy efficiency, reliability, color quality, etc., there still appears to be a desire for new white light emitting lighting devices. Hence, it is an aspect of the invention to provide an alternative light generating system (or lighting device), which preferably further at least partly obviates one or more of above-described drawbacks. The present invention may have as object to overcome or ameliorate at least one of the disadvantages of the prior art, or to provide a useful alternative.

The invention provides a light generating system comprising a light generating device, a first luminescent material, a second luminescent material, and a third luminescent material, wherein: (A) the light generating device is configured to generate device light having a peak wavelength selected from the range of 435-475 nm; wherein the light generating device comprises a solid state light source; (B) the first luminescent material is configured to convert part of the device light into first luminescent material light having a color point with u' values selected from the range of 0.08-0.17 and v' values selected from the range of 0.5-0.57; (C) the second luminescent material is configured to convert part of the device light into second luminescent material light having a color point with u' values selected from the range of 0.32-0.4 and v' values selected from the range of 0.52-0.58; (D) the third luminescent material is configured to convert part of the device light into third luminescent material light; wherein the third luminescent material has a centroid wavelength (λ3c) selected from the range of 620-650 nm and a full width half maximum of 60 nm or smaller; (E) the light generating system is configured to generate system light having a (system light) spectral power distribution comprising device light, first luminescent material light, second luminescent material light, and third luminescent material light; wherein the (system light) spectral power distribution has a first spectral power (E₁ₚ) at a first peak maximum (λ1p) of the device light and a second spectral power (Eₘ) at a minimum between the first peak maximum (λ1p) of the device light and a second peak maximum (λ2p) of the first luminescent material light; and (F) the light generating device and the luminescent materials are selected such that 1.0≤E₁ₚ/Eₘ≤2.5, and the light generating device and the luminescent materials are selected such that the system light has a color rendering index selected from the range of at least 85, and a correlated color temperature selected from the range of 2000-8000 K. Preferably the system light is white light.

With such light generating system, white light can be generated with a relatively high CRI. Further, a relatively continuous spectral power distribution may be provided with a relatively smally "cyan-gap". A relatively small or substantially no cyan gap may give a more "filled" spectrum which may be perceived as more natural daylight, and may give some enhanced circadian rhythm (melanopic) stimulation compared to regular white light. Further, a relatively flat intensity in the blue-cyan spectral range may give a benefit in terms of photobiological safety and/or less eye fatigue compared to regular white LED light which has a pronounced blue peak. Further, such light generating system may provide white light relatively efficiently.

As indicated above, the light generating system comprises a light generating device, a first luminescent material, a second luminescent material, and a third luminescent material. These are further discussed below.

The term "solid state light source", or "solid state material light source", and similar terms, may especially refer to semiconductor light sources, such as a light emitting diode (LED), a diode laser, or a superluminescent diode. In the invention, the light generating device comprises a solid state light source, such as a LED. Hence, in embodiments the light generating device may comprise a light emitting diode (LED). In specific embodiments, the light generating device may comprise a plurality of LEDs (see further also below). Hence, the system may comprise in embodiments a plurality of light generating devices (which may in specific embodiments all provide device light having essentially the same spectral power distributions).

As can be derived from the above, the light generating device is configured to generate device light, especially having a peak wavelength selected from the range of 435-475 nm. With such wavelengths, some useful luminescent materials may be excited, whereas also light is generated that may be used as blue component in the spectral power distribution of the system light. In further specific embodiments, the device light has a peak wavelength selected from the range of 445-465 nm.

As indicated above, the light generating system may comprise one or more luminescent materials, especially at least three different luminescent materials. These may be configured downstream of the (first) light generating device(s).

The term "luminescent material" especially refers to a material that can convert first radiation, especially one or more of UV radiation and blue radiation, into second radiation. In general, the first radiation and second radiation have different spectral power distributions. Hence, instead of the term "luminescent material", also the terms "luminescent converter" or "converter" may be applied. In general, the second radiation has a spectral power distribution at larger wavelengths than the first radiation, which is the case in the so-called down-conversion. In specific embodiments, however the second radiation has a spectral power distribution with intensity at smaller wavelengths than the first radiation, which is the case in the so-called up-conversion.

In embodiments, the "luminescent material" may especially refer to a material that can convert radiation into e.g. visible and/or infrared light. For instance, in embodiments the luminescent material may be able to convert one or more of UV radiation and blue radiation, into visible light. The luminescent material may in specific embodiments also convert radiation into infrared radiation (IR). Hence, upon excitation with radiation, the luminescent material emits radiation. In general, the luminescent material will be a down converter, i.e. radiation of a smaller wavelength is converted into radiation with a larger wavelength (λₑₓ<λₑₘ), though in specific embodiments the luminescent material may comprise up-converter luminescent material, i.e. radiation of a larger wavelength is converted into radiation with a smaller wavelength (λₑₓ>λₑₘ).

In embodiments, the term "luminescence" may refer to phosphorescence. In embodiments, the term "luminescence" may also refer to fluorescence. Instead of the term "luminescence", also the term "emission" may be applied. Hence, the terms "first radiation" and "second radiation" may refer to excitation radiation and emission (radiation), respectively. Likewise, the term "luminescent material" may in embodiments refer to phosphorescence and/or fluorescence.

The term "luminescent material" may also refer to a plurality of different luminescent materials. Examples of possible luminescent materials are indicated below. Hence, the term "luminescent material" may in specific embodiments also refer to a luminescent material composition. Instead of the term "luminescent material" also the term "phosphor" may be applied. These terms are known to the person skilled in the art.

In embodiments, luminescent materials are selected from garnets and nitrides, especially doped with trivalent cerium or divalent europium, respectively. The term "nitride" may also refer to oxynitride or nitridosilicate, etc. Alternatively or additionally, the luminescent material(s) may be selected from silicates, especially doped with divalent europium.

In specific embodiments the luminescent material comprises a luminescent material of the type A₃B₅O₁₂:Ce, wherein A in embodiments comprises one or more of Y, La, Gd, Tb and Lu, especially (at least) one or more of Y, Gd, Tb and Lu, and wherein B in embodiments comprises one or more of Al, Ga, In and Sc. Especially, A may comprise one or more of Y, Gd and Lu, such as especially one or more of Y and Lu. In embodiments, the molar ratio of yttrium and lutetium may be Y/Lu≤0.5, such as Y/Lu≤0.3. In embodiments, Y may even essentially be absent.

In embodiments, B may comprise one or more of Al and Ga, more especially at least Al, such as essentially entirely Al. In other embodiments, B may comprise one or more of Al and Ga, more especially at least Ga. The former embodiments may show an emission that is red-shifted relative to an emission of the latter embodiments; or, the latter embodiments show an emission that may be relatively blue-shifted relative to the former embodiments. Especially, herein the blue-shifted garnet type luminescent material may be of interest, as they may allow a relatively shallow cyan gap. Hence, in embodiments, the molar ratio of aluminum and gallium may be Al/Ga≤0.5, such as Al/Ga≤0.3. In embodiments, Al may even essentially be absent.

Hence, especially suitable luminescent materials are cerium comprising garnet materials. Embodiments of garnets especially include A₃B₅O₁₂ garnets, wherein A comprises at least yttrium or lutetium and wherein B comprises at least aluminum. Such garnets may be doped with cerium (Ce), with praseodymium (Pr) or a combination of cerium and praseodymium; especially however with Ce. Especially, B may comprise aluminum (Al); however, in addition to aluminum, B may also partly comprise gallium (Ga) and/or scandium (Sc) and/or indium (In), especially up to about 20% of B, more especially up to about 10 % of B (i.e. the B ions essentially consist of 90 or more mole % of Al and 10 or less mole % of one or more of Ga, Sc and In); B may especially comprise up to about 10% gallium. In another variant, B and O may at least partly be replaced by Si and N. The element A may especially be selected from the group consisting of yttrium (Y), gadolinium (Gd), terbium (Tb) and lutetium (Lu). Further, Gd and/or Tb are especially only present up to an amount of about 20% of A. In a specific embodiment, the garnet luminescent material comprises (Y₁₋ₓLuₓ)₃B₅O₁₂:Ce, wherein x is equal to or larger than 0 and equal to or smaller than 1. The term ":Ce", indicates that part of the metal ions (i.e. in the garnets: part of the "A" ions) in the luminescent material is replaced by Ce. For instance, in the case of (Y₁₋ₓLuₓ)₃Al₅O₁₂:Ce, part of Y and/or Lu is replaced by Ce. This is known to the person skilled in the art. Ce will replace A in general for not more than 10%; in general, the Ce concentration will be in the range of 0.1 to 4%, especially 0.1 to 2% (relative to A). Assuming 1% Ce and 10% Y, the full correct formula could be (Y_{0.1}Lu_{0.89}Ce_{0.01})₃Al₅O₁₂. Ce in garnets is substantially or only in the trivalent state, as is known to the person skilled in the art.

In embodiments, the luminescent material (thus) comprises A₃B₅O₁₂ wherein in specific embodiments at maximum 10% of B-O may be replaced by Si-N.

In specific embodiments the luminescent material comprises (Yₓ₁A'ₓ₂Ceₓ₃)₃(Al_{y1}B'_{y2})₅O₁₂, wherein x1+x2+x3=1, wherein x3>0, wherein 0<x2+x3≤0.2, wherein y1+y2=1, wherein 0≤y2≤0.2, wherein A' comprises one or more elements selected from the group consisting of lanthanides, and wherein B' comprises one or more elements selected from the group consisting of Ga, In and Sc. In embodiments, x3 is selected from the range of 0.001-0.1. In the present invention, especially x1>0, such as >0.2, like at least 0.8. Garnets with Y may provide suitable spectral power distributions.

In specific embodiments at maximum 10% of B-O may be replaced by Si-N. Here, B in B-O refers to one or more of Al, Ga, In and Sc (and O refers to oxygen); in specific embodiments B-O may refer to Al-O. As indicated above, in specific embodiments x3 may be selected from the range of 0.001-0.04. Especially, such luminescent materials may have a suitable spectral distribution (see however below), have a relatively high efficiency, have a relatively high thermal stability, and allow a high CRI (optionally in combination with (the) light of other sources of light as described herein). Hence, in specific embodiments A may be selected from the group consisting of Lu and Gd. Alternatively or additionally, B may comprise Ga. Hence, in embodiments the luminescent material comprises (Yₓ₁(Lu,Gd)ₓ₂Ceₓ₃)₃(Al_{y1}Ga_{y2})₅O₁₂, wherein Lu and/or Gd may be available. Even more especially, x3 is selected from the range of 0.001-0.1, wherein 0<x2+x3≤0.1, and wherein 0≤y2≤0.1. Further, in specific embodiments, at maximum 1% of B-O may be replaced by SiN. Here, the percentage refers to moles (as known in the art); see e.g. also EP3149108. In yet further specific embodiments, the luminescent material comprises (Yₓ₁Ceₓ₃)₃Al₅O₁₂, wherein x1+x3=1, and wherein 0<x3≤0.2, such as 0.001-0.1. In specific embodiments, A may especially comprise at least Y, and B may especially comprise at least Al. In other specific embodiments, however, A may especially comprise at least one or more of Gd and Lu, and B may especially comprise at least Ga. In embodiments, the molar ratio of yttrium and lutetium and gadolinium may be Y/(Lu+Gd) ≤0.5, such as Y/(Lu+Gd)≤0.3. In embodiments, Y may even essentially be absent.

Alternatively or additionally, wherein the luminescent material may comprises a luminescent material of the type A₃Si₆N₁₁:Ce³⁺, wherein A comprises one or more of Y, La, Gd, Tb and Lu, such as in embodiments one or more of La and Y.

In embodiments, the luminescent material may alternatively or additionally comprise one or more of MS:Eu²⁺ and/or M₂Si₅N₈:Eu²⁺ and/or MAlSiN₃:Eu²⁺ and/or Ca₂AlSi₃O₂N₅:Eu²⁺, etc., wherein M comprises one or more of Ba, Sr, and Ca, especially in embodiments at least Sr. Hence, in embodiments, the luminescent material may comprise one or more materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr or Ba. The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Further, the material (Ba,Sr,Ca)₂Si₅N₈:Eu can also be indicated as M₂Si₅N₈:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50 to 100%, more especially 50 to 90% Ba and 50 to 0%, especially 50 to 10% Sr, such as Ba_{1.5}Sr_{0.5}Si₅N₈:Eu (i.e. 75 % Ba; 25% Sr). Here, Eu is introduced and replaces at least part of M, i.e. one or more of Ba, Sr, and Ca). Likewise, the material (Ba,Sr,Ca)AlSiN₃:Eu can also be indicated as MAlSiN₃:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Eu in the above indicated luminescent materials is substantially or only in the divalent state, as is known to the person skilled in the art.

In embodiments, a red luminescent material may comprise one or more materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr or Ba.

The material (Ba,Sr,Ca)S:Eu can also be indicated as MS:Eu, wherein M is one or more elements selected from the group consisting of barium (Ba), strontium (Sr), and calcium (Ca); especially, M comprises in this compound calcium or strontium, or calcium and strontium, more especially calcium. Here, Eu is introduced and replaces at least part of M (i.e. one or more of Ba, Sr, and Ca).

Further, the material (Ba,Sr,Ca)₂Si₅N₈:Eu can also be indicated as M₂Si₅N₈:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50 to 100%, more especially 50 to 90% Ba and 50 to 0%, especially 50 to 10% Sr, such as Ba_{1.5}Sr_{0.5}Si₅N₈:Eu (i.e. 75 % Ba; 25% Sr). Here, Eu is introduced and replaces at least part of M, i.e. one or more of Ba, Sr, and Ca).

Likewise, the material (Ba,Sr,Ca)AlSiN₃:Eu can also be indicated as MAlSiN₃:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Eu in the above indicated luminescent materials is substantially or only in the divalent state, as is known to the person skilled in the art.

Blue luminescent materials may comprise YSO (Y₂SiO₅:Ce³⁺), or similar compounds, or BAM (BaMgAl₁₀O₁₇:Eu²⁺), or similar compounds.

The term "luminescent material" herein especially relates to inorganic luminescent materials.

Alternatively or additionally, also other luminescent materials may be applied. For instance quantum dots and/or organic dyes may be applied and may optionally be embedded in transmissive matrices like e.g. polymers, like PMMA, or polysiloxanes, etc. etc..

Quantum dots are small crystals of semiconducting material generally having a width or diameter of only a few nanometers. When excited by incident light, a quantum dot emits light of a color determined by the size and material of the crystal. Light of a particular color can therefore be produced by adapting the size of the dots. Most known quantum dots with emission in the visible range are based on cadmium selenide (CdSe) with a shell such as cadmium sulfide (CdS) and zinc sulfide (ZnS). Cadmium free quantum dots such as indium phosphide (InP), and copper indium sulfide (CuInS₂) and/or silver indium sulfide (AgInS₂) can also be used. Quantum dots show very narrow emission band and thus they show saturated colors. Furthermore the emission color can easily be tuned by adapting the size of the quantum dots. Any type of quantum dot known in the art may be used in the present invention. However, it may be preferred for reasons of environmental safety and concern to use cadmium-free quantum dots or at least quantum dots having a very low cadmium content.

Instead of quantum dots or in addition to quantum dots, also other quantum confinement structures may be used. The term "quantum confinement structures" should, in the context of the present application, be understood as e.g. quantum wells, quantum dots, quantum rods, tripods, tetrapods, or nano-wires, etcetera.

Organic phosphors can be used as well. Examples of suitable organic phosphor materials are organic luminescent materials based on perylene derivatives, for example compounds sold under the name Lumogen^{®} by BASF. Examples of suitable compounds include, but are not limited to, Lumogen^{®} Red F305, Lumogen^{®} Orange F240, Lumogen^{®} Yellow F083, and Lumogen^{®} F170.

Different luminescent materials may have different spectral power distributions of the respective luminescent material light. Alternatively or additionally, such different luminescent materials may especially have different color points (or dominant wavelengths).

As indicated above, other luminescent materials may also be possible. Hence, in specific embodiments the luminescent material is selected from the group of divalent europium containing nitrides, divalent europium containing oxynitrides, divalent europium containing silicates, cerium comprising garnets, and quantum structures. Quantum structures may e.g. comprise quantum dots or quantum rods (or other quantum type particles) (see above). Quantum structures may also comprise quantum wells. Quantum structures may also comprise photonic crystals.

Especially, the first luminescent material may comprise a luminescent material that emits in the green-yellow wavelength range, especially substantially in the green wavelength range. Especially, the first luminescent material light of the first luminescent material may be a relatively broad band in the spectral power distribution (see also below).

In the invention, the first luminescent material is configured to convert part of the device light into first luminescent material light having a color point with u' values selected from the range of 0.08-0.17 and v' values selected from the range of 0.50-0.57. More especially, a color point with u' values selected from the range of 0.10-0.15 and v' values selected from the range of 0.52-0.55 may be selected.

Especially, the second luminescent material may comprise a luminescent material that emits in the yellow-red wavelength range, especially substantially in the orange-red wavelength range. More especially at least part of the first luminescent material of the first luminescent material may be in the orange wavelength range. Further, especially the second luminescent material light of the second luminescent material may be a relatively broad band in the spectral power distribution (see also below).

In the invention, the second luminescent material is configured to convert part of the device light into second luminescent material light having a color point with u' values selected from the range of 0.32-0.40 and v' values selected from the range of 0.52-0.58. More especially, a color point with u' values selected from the range of 0.33-0.38 and v' values selected from the range of 0.54-0.56 may be selected.

Especially, the third luminescent material may comprise a luminescent material that emits in the red wavelength range, especially with a substantial part of the emission at wavelengths larger than about 625 nm. Further, especially the third luminescent material light of the third luminescent material may be a relatively narrow band in the spectral power distribution (see also below).

In the invention, the third luminescent material is configured to convert part of the device light into third luminescent material light. The third luminescent material has one or more of (i) a centroid wavelength (λ3c) selected from the range of 620-650 nm and (ii) a full width half maximum of 60 nm or smaller. Further, in specific embodiments the third luminescent material may be configured to convert part of the device light into third luminescent material light having a color point with u' values selected from the range of 0.44-0.63 and v' values selected from the range of 0.48-0.55, more especially with u' values selected from the range of 0.46-0.61 and v' values selected from the range of 0.50-0.53.

The term "centroid wavelength", also indicated as λc, is known in the art, and refers to the wavelength value where half of the light energy is at shorter and half the energy is at longer wavelengths; the value is stated in nanometers (nm). It is the wavelength that divides the integral of a spectral power distribution into two equal parts as expressed by the formula λc = Σ λ*I(λ) / (Σ I( λ)), where the summation is over the wavelength range of interest, and I(λ) is the spectral energy density (i.e. the integration of the product of the wavelength and the intensity over the emission band normalized to the integrated intensity). The centroid wavelength may e.g. be determined at operation conditions.

With luminescent materials having such optical properties, and with optical properties of the light generating device, a desirable spectral power distribution of the system light may be provided.

The light generating system is configured to generate system light having a spectral power distribution (or "system light spectral power distribution") comprising device light, first luminescent material light, second luminescent material light, and third luminescent material light. Such system light has a (system light) spectral power distribution having a first spectral power (E₁ₚ) at a first peak maximum (λ1p) of the device light and a second spectral power (Eₘ) at a minimum between the first peak maximum (λ1p) of the device light and a second peak maximum (λ2p) of the first luminescent material light. Especially, this minimum may be a gap in the blue-green wavelength range (such as a gap in the cyan wavelength range). It appears that with the present invention, this gap may be relatively shallow. In the invention, the light generating device and the luminescent materials are selected such that 1.0≤E₁ₚ/Eₘ≤2.5. In embodiments, the light generating device and the luminescent materials may be selected such that 1.0<E₁ₚ/Eₘ≤2.0, when the system light has a correlated color temperature of at maximum 5000 K, and selected such that 1.0≤E₁ₚ/Eₘ≤2.5, such as at least about 1.2, yet more especially 1.5≤E₁ₚ/Eₘ≤2.5, when the system light has a correlated color temperature above 5000 K.

Herein, the terms "violet light" or "violet emission", and similar terms, may especially relate to light having a wavelength in the range of about 380-440 nm. In specific embodiments, the violet light may have a centroid wavelength in the 380-440 nm range. The terms "blue light" or "blue emission", and similar terms, may especially relate to light having a wavelength in the range of about 440-490 nm (including some violet and cyan hues). In specific embodiments, the blue light may have a centroid wavelength in the 440-490 nm range. The terms "green light" or "green emission", and similar terms, may especially relate to light having a wavelength in the range of about 490-560 nm. In specific embodiments, the green light may have a centroid wavelength in the 490-560 nm range. The terms "yellow light" or "yellow emission", and similar terms, may especially relate to light having a wavelength in the range of about 560-590 nm. In specific embodiments, the yellow light may have a centroid wavelength in the 560-590 nm range. The terms "orange light" or "orange emission", and similar terms, may especially relate to light having a wavelength in the range of about 590-620 nm. In specific embodiments, the orange light may have a centroid wavelength in the 590-620 nm range. The terms "red light" or "red emission", and similar terms, may especially relate to light having a wavelength in the range of about 620-750 nm. In specific embodiments, the red light may have a centroid wavelength in the 620-750 nm range. The terms "cyan light" or "cyan emission", and similar terms, especially relate to light having a wavelength in the range of about 490-520 nm. In specific embodiments, the cyan light may have a centroid wavelength in the 490-520 nm range. The terms "amber light" or "amber emission", and similar terms, may especially relate to light having a wavelength in the range of about 585-605 nm, such as about 590-600 nm. In specific embodiments, the amber light may have a centroid wavelength in the 585-605 nm range. The phrase "light having one or more wavelengths in a wavelength range" and similar phrases may especially indicate that the indicated light (or radiation) has a spectral power distribution with at least intensity or intensities at these one or more wavelengths in the indicate wavelength range. For instance, a blue emitting solid state light source will have a spectral power distribution with intensities at one or more wavelengths in the 440-495 nm wavelength range.

The terms "visible", "visible light" or "visible emission" and similar terms refer to light having one or more wavelengths in the range of about 380-780 nm. Herein, UV may especially refer to a wavelength selected from the range of 190-380 nm, such as 200-380 nm.

Here below, some embodiments of the luminescent materials are described, starting with the third luminescent material.

Especially, the third luminescent may be a relatively narrow band emitter. With such luminescent material(s), the efficiency may be relatively high, while CRI may also be high. A broad band emitter in the (far) red may be less efficient. In the invention, the third luminescent material may comprise one or more emission bands, having full width half maxima (FWHM) of at maximum 60 nm, such as at maximum 50 nm. In specific embodiments, the third luminescent material may comprise one or more emission lines, having full width half maxima of at maximum about 30 nm, more especially at maximum 20 nm.

In specific embodiments, the third luminescent material comprises a luminescent material of the type M'ₓM₂₋₂ₓAX₆ doped with tetravalent manganese, wherein M' comprises an alkaline earth cation, M comprises an alkaline cation, and x is in the range of 0-1, wherein A comprises a tetravalent cation, comprising one or more of silicon and titanium, wherein X comprises a monovalent anion, at least comprising fluorine.

A luminescent material of the type M'ₓM₂₋₂ₓAX₆ doped with tetravalent manganese is amongst others described in WO2013121355A1. Passages from WO2013121355A1 are also copied herein.

Herein, M'ₓM₂₋₂ₓAX₆ doped with tetravalent manganese, may further also shortly be indicated as "phosphor", i.e. the phrase " phosphor comprising M'ₓM₂₋₂ₓAX₆ doped with tetravalent manganese" may in an embodiment also be read as M'ₓM₂₋₂ₓAX₆ doped with tetravalent manganese phosphor, or (tetravalent) Mn-doped M'ₓM₂₋₂ₓAX₆ phosphor, or shortly "phosphor".

Relevant alkaline cations (M) are sodium (Na), potassium (K) and rubidium (Rb). Optionally, also lithium and/or cesium may be applied. In a preferred embodiment, M comprises at least potassium. In yet another embodiment, M comprises at least rubidium. The phrase "wherein M comprises at least potassium" indicates for instance that of all M cations in a mole M'ₓM₂₋₂ₓAX₆, a fraction comprises K⁺ and an optionally remaining fraction comprises one or more other monovalent (alkaline) cations (see also below). In another preferred embodiment, M comprises at least potassium and rubidium. Optionally, the M'ₓM₂₋₂ₓAX₆ luminescent material has the hexagonal phase. In yet another embodiment, the M'ₓM₂₋₂ₓAX₆ luminescent material has the cubic phase.

Relevant alkaline earth cations (M') are magnesium (Mg), strontium (Sr), calcium (Ca) and barium (Ba), especially one or more of Sr and Ba.

In an embodiment, a combination of different alkaline cations may be applied. In yet another embodiment, a combination of different alkaline earth cations may be applied. In yet another embodiment, a combination of one or more alkaline cations and one or more alkaline earth cations may be applied. For instance, KRb_{0.5}Sr_{0.25}AX₆ might be applied. As indicated above, x may be in the range of 0-1, especially x<1. In an embodiment, x=0.

The term "tetravalent manganese" refers to Mn⁴⁺. This is a well-known luminescent ion. In the formula as indicated above, part of the tetravalent cation A (such as Si) is being replaced by manganese. Hence, M'ₓM₂₋₂ₓAX₆ doped with tetravalent manganese may also be indicated as M'ₓM₂₋₂ₓA₁₋ₘMnₘX₆. The mole percentage of manganese, i.e. the percentage it replaces the tetravalent cation A will in general be in the range of 0.1-15 %, especially 1-12 %, i.e. m is in the range of 0.001-0.15, especially in the range of 0.01-0.12.

A comprises a tetravalent cation, and preferably at least comprises silicon. A may optionally (further) comprise one or more of titanium (Ti), germanium (Ge), stannum (Sn) and zinc (Zn). Preferably, at least 80%, even more preferably at least 90%, such as at least 95% of M consists of silicon. Hence, in a specific embodiment, M'ₓM₂₋₂ₓAX₆ may also be described as M'ₓM₂₋₂ₓA_{1-m-t-g-s-zr}MnₘTiₜGe_{g}SnₛZr_{zr}X₆, wherein m and x are as indicated above, and wherein t,g,s,zr are each individually preferably in the range of 0-0.2, especially 0-0.1, even more especially 0-0.05, wherein t+g+s+zr is smaller than 1, especially equal to or smaller than 0.2, preferably in the range of 0-0.2, especially 0-0.1, even more especially 0-0.05, and wherein A is especially Si. X is preferably fluorine (F).

As indicated above, M relates to monovalent cations, but preferably at least comprises potassium and/or rubidium. Other monovalent cations that may further be comprised by M can be selected from the group consisting of lithium (Li), sodium (Na), cesium (Cs) and ammonium (NH₄⁺). In an embodiment, preferably at least 80%(i.e. 80% of all moles of the type M), even more preferably at least 90%, such as 95% of M consists of potassium and/or rubidium. Especially, in these embodiments x is thus zero.

Hence, in a specific embodiment, M'ₓM₂₋₂ₓAX₆ can also be described as (K_{1-r-l-n-c-nh} RbᵣLiₗNaₙCs_{c}(NH₄)ₙₕ)₂AX₆, wherein r is in the range of 0-1, wherein l,n,c,nh are each individually preferably in the range of 0-1, preferably 0-0.2, especially 0-0.1, even more especially 0-0.05, and wherein r+l+n+c+nh is in the range of 0-1, especially l+n+c+nh is smaller than 1, especially equal to or smaller than 0.2, preferably in the range of 0-0.2, especially 0-0.1, even more especially 0-0.05. X is preferably fluorine (F).

As indicated above, instead of or in addition to the alkaline cation(s), also one or more alkaline earth cations may be present. Hence, in a specific embodiment, M'ₓM₂₋₂ₓAX₆ can also be described as Mg_{mg}Ca_{ca}SrₛᵣBa_{ba}(KₖRbᵣLiₗNaₙCs_{c}(NH₄)ₙₕ)₂AX₆, with k, r, l, n, c, nh each individually being in the range of 0-1, wherein mg, ca, sr, ba are each individually in the range of 0-1, and wherein mg+ca+sr+ba+k+ r+ l+n+c+nh=1. In embodiments, k=1, and the others (mg, ca, sr, ba, r, l, n, c, nh) are zero.

As indicated above, X relates to a monovalent anion, but at least comprises fluorine. Other monovalent anions that may optionally be present may be selected from the group consisting of chlorine (Cl), bromine (Br), and iodine (I). Preferably, at least 80%, even more preferably at least 90%, such as 95% of X consists of fluorine. Hence, in a specific embodiment, M'ₓM₂₋₂ₓAX₆ can also be described as M'ₓM₂₋₂ₓA(F_{1-cl-b-i}Cl_{cl}Br_{b}Iᵢ)₆, wherein cl,b,i are each individually preferably in the range of 0-0.2, especially 0-0.1, even more especially 0-0.05, and wherein cl+b+i is smaller than 1, especially equal to or smaller than 0.2, preferably in the range of 0-0.2, especially 0-0.1, even more especially 0-0.05. Especially, X essentially consists of F (fluorine).

Hence, M'ₓM₂₋₂ₓAX₆ can also be described as (K_{1-r-l-n-c-nh} RbᵣLiₗNaₙCs_{c}(NH₄)ₙₕ)₂Si_{1-m-t-g-s-zr}MnₘTiₜGe_{g}SnₛZr_{zr}(F_{1-cl-b-i}Cl_{cl}Br_{b}Iᵢ)₆, with the values for r,l,n,c,nh,m,t,g,s,zr,cl,b,i as indicated above. X is preferably fluorine (F).

Even more especially, M'ₓM₂₋₂ₓAX₆ can also be described as Mg_{mg}Ca_{ca}SrₛᵣBa_{ba}(KₖRbᵣLiₗNaₙCs_{c}(NH₄)ₙₕ)₂Si_{1-m-t-g-s-zr}MnₘTiₜGe_{g}SnₛZr_{zr}(F_{1-cl-b-i}Cl_{cl}Br_{b}Iᵢ)₆, with k, r, l, n, c, nh each individually being in the range of 0-1, wherein mg, ca, sr, ba are each individually in the range of 0-1, wherein mg+ca+sr+ba+k+ r+l+n+c+nh=1, and with the values for m,t,g,s,zr,cl,b,i as indicated above. X is preferably fluorine (F).

In a preferred embodiment, M'ₓM₂₋₂ₓAX₆ comprises K₂SiF₆ (indicated herein also as KSiF system). As indicated above, in another preferred embodiment, M'ₓM₂₋₂ₓAX₆ comprises KRbSiF₆ (i.e. r=0.5 and l,n,c,nh,t,g,s,zr,cl,b,i are 0) (herein also indicated as K,Rb system). As indicated above, part of silicon is replaced by manganese (i.e. the formula may also be described as K₂Si₁₋ₘMnₘF₆ or KRbSi₁₋ₘMnₘF₆, with m as indicated above, or as KRbSiF₆:Mn and K₂SiF₆:Mn, respectively). As manganese replaces part of a host lattice ion and has a specific function, it is also indicated as "dopant" or "activator". Hence, the hexafluorosilicate is doped or activated with manganese (Mn⁴⁺).

The luminescent material may also be coated, as also described in WO2013121355A1.

In embodiments, the third luminescent material may comprise (K,Rb)₂SiF₆:Mn⁴⁺. Alternatively or additionally, in embodiments the third luminescent material may comprise K₂SiF₆:Mn⁴⁺. Alternatively or additionally, in embodiments the third luminescent material may comprise K₂TiF₆:Mn⁴⁺. In embodiments, the third luminescent material may comprise K₂(Si,Ti)F₆:Mn⁴⁺. As can be derived from the above, "Si,Ti" may indicate one or more of Si and Ti.

Such third luminescent material may, upon excitation by the device light, provide third luminescent material light having emission lines (in the red wavelenght range) having full width half maxima of at maximum about 20 nm.

Instead of or in addition to the luminescent material of the type M'ₓM₂₋₂ₓAX₆ doped with tetravalent manganese, it is also possible to use a quantum structure based luminescent material. Hence, in embodiments the third luminescent material comprises a quantum structure based luminescent material, such as e.g. wherein the third luminescent material comprises quantum dots. Herein, the term "quantum structure based luminescent material" may also be indicated as "quantum structure" or "quantum confinement structure". Examples of quantum structures are also given above: the term "quantum confinement structures" should, in the context of the present application, be understood as e.g. quantum wells, quantum dots, quantum rods, tripods, tetrapods, or nano-wires, etcetera. Quantum structures may also comprise photonic crystals. Quantum structure based luminescent material may comprise e.g. semiconductor materials.

Examples of quantum structure based luminescent material (such as semiconductor nanocrystal (core)shell materials) include, without limitation: red (e.g., (CdSe)ZnS (core)shell), green (e.g., (CdZnSe)CdZnS (core)shell, etc.), and blue (e.g., (CdS)CdZnS (core)shell (see further also above for examples of specific wavelength converter nanoparticles, based on semiconductors). Herein, the terms "semiconductor nanocrystal" and "QD" are used interchangeably. Another term for quantum dots is luminescent nanocrystal. Hence, the above-mentioned outer surface may be the surface of a bare quantum dot (i.e. a QD not comprising a further shell or coating) or may be the surface of a coated quantum dot, such as a core-shell quantum dot (like core-shell or dot-in-rod), i.e. the (outer) surface of the shell. Therefore, in a specific embodiment, the wavelength converter nanoparticles are selected from the group consisting of core-shell nano particles, with the cores and shells comprising one or more of CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, CdZnSeS, CdZnSeTe, CdZnSTe, CdHgSeS, CdHgSeTe, CdHgSTe, HgZnSeS, HgZnSeTe, HgZnSTe, GaN, GaP, GaAs, AIN, AlP, AlAs, InN, InP, InAs, GaNP, GaNAs, GaPAs, AlNP, AlNAs, AlPAs, InNP, InNAs, InPAs, GaAlNP, GaAINAs, GaAlPAs, GaInNP, GaInNAs, GaInPAs, InAlNP, InAlNAs, and InAlPAs. In general, the cores and shells comprise the same class of material, but essentially consist of different materials, like a ZnS shell surrounding a CdSe core, etc. In an embodiment, the quantum dots comprise core/shell luminescent nanocrystals comprising CdSe/ZnS, InP/ZnS, InP/ZnSe, InP/ZnSe₁₋ₓSₓ, PbSe/PbS, CdSe/CdS, CdTe/CdS or CdTe/ZnS.

In specific embodiments, relative to a total weight of the luminescent materials, the third luminescent material may be available in an amount such that in the total spectral power distribution in the visible (i.e. 380-780 nm), up to at maximum about 25% of the spectral power is provided by the third luminescent material light. For intsance, in embodiments the third luminescent material may be available in an amount such that in the total spectral power distribution in the visible, wherein a minimum of about 1% of the spectral power is provided by the third luminescent material light.

In embodiments, in the range of 0.01-15 wt%, such as especially 2-8 wt%, of the luminescent materials may be provided by quantum structure based luminescent material. Alternatively, in embodiments in the range of about 5-60 wt% of the luminescent materials may be provided by the manganese based luminescent material. Other values, however, may also be possible.

Below, some embodiments of the first luminescent material and the second luminescent material are described, with reference to some above described luminescent materials.

In embodiments, both the first luminescent material light and the second luminescent material light may have full width half maxima in the spectral power distribution of the system light of at least 60 nm, such as more especially at least 70 nm. For instance, the FWHM of the first luminescent material light and/or the FWHM of the second luminescent material light may especially be at least 80 nm. Of course, the FWHMs may differ, as the first luminescent material and the second luminescent material may be different luminescent materials.

In specific embodiments, the first luminescent material is of the garnet type, doped with cerium. In embodiments the first luminescent material may comprise a luminescent material of the type A₃B₅O₁₂:Ce, wherein A comprises one or more of Y, La, Gd, Tb and Lu, and wherein B comprises one or more of Al, Ga, In and Sc (see further also above). Especially, in embodiments A comprises Lu and/or B comprises Ga. In this way, the emission may be blue shifted, e.g. relative to Y₃Al₅O₁₂:Ce³⁺.

In specific embodiments, the second luminescent material is of the nitride type, doped with divalent europium. In embodiments, the second luminescent material may comprise a luminescent material of the type MAlSiN₃:Eu, wherein M is one or more elements selected from the group consisting of Ba, Sr, and Ca (see further also above). Especially, in embodiments M may comprise Sr. However, M may also comprise Ca. In specific embodiments, M may comprise Ca and Sr. This may provide a luminescent material with the desired (optical) properties.

The luminescent materials may be configured downstream of the light generating device. Especially, the luminescent material may be configured downstream of a plurality of light generating devices.

The terms "upstream" and "downstream" relate to an arrangement of items or features relative to the propagation of the light from a light generating means (here the especially the light source), wherein relative to a first position within a beam of light from the light generating means, a second position in the beam of light closer to the light generating means is "upstream", and a third position within the beam of light further away from the light generating means is "downstream".

The luminescent materials may be configured remote from the one or more light generating devices. In other embodiments, at least part of the luminescent materials may be configured in (physical) contact with the one or more light generating devices.

The luminescent materials may be provided as a single layer comprising all luminescent materials, or may be provided as multi-layer coating wherein one or more layers comprise different compositions of the luminescent materials. The luminescent materials may be provided as coating on the one or more light generating devices. The luminescent materials may be embedded in another materials, such as a polymeric materials, which may be provided as body or a (coating) layer.

The luminescent materials may be configured in the reflective mode or in the transmissive mode. In the transmissive mode, it may be relatively easy to have light source light admixed in the luminescent materials light, which may be useful for generating the desirable spectral power distribution. In the reflective mode, thermal management may be more easy, as a substantial part of the luminescent materials may be in thermal contact with a thermally conductive element, like a heatsink or heat spreader. In the reflective mode, a part of the light source light may in embodiments be reflected by the luminescent materials and/or a reflector and may be admixed in the luminescent materials light. The reflector may be configured downstream of the luminescent materials (in the reflective mode). Especially, herein the luminescent materials are configured in the transmissive mode.

In embodiments, the light generating system may comprise a plurality of light generating devices and a luminescent layer configured downstream of the plurality of light generating devices, wherein the luminescent layer comprises the first luminescent material, the second luminescent material, and the third luminescent material.

Especially, in embodiments, the light generating system may comprise a chip-on-board light generating device, wherein the chip-on-board light generating device comprises a plurality of light generating devices and a luminescent layer configured downstream of the plurality of light generating devices. Especially, the luminescent layer may comprise the first luminescent material, the second luminescent material, and the third luminescent material. Alternatively, the light generating system may comprise a dome-shaped body configured downstream of the light generating device. The dome-shaped body may comprise the first luminescent material, the second luminescent material, and the third luminescent material. Yet alternatively, the light generating system may comprise a reflector cup, wherein the luminescent material is configured. The light generating device may be configured at least partly in the reflector cup. The luminescent material may be provided as such or may be comprised by a light transmissive body in the reflector cup, such as dispersed in a resin (e.g. silicone). Yet alternatively, the light generating system may comprise a LED filament.

In embodiments, a LED filament may comprise an elongated substrate. In embodiments, the elongated substrate may be light transmissive (for the LED light, see below). The substrate may have a first main surface at a first side of the substrate and a second main surface at a second side of the substrate, opposite to the first side. A plurality of LEDs may be mounted onto the first main surface and configured to emit LED light. An encapsulant may cover the plurality of LEDs (on the first main surface) and at least part of the first main surface, and optionally also at least part of the second main surface. Optionally, a plurality of LEDs may also be mounted onto the second main surface and be configured to emit LED light. The encapsulant may also cover the plurality of LEDs (on the second main surface) (and at least part of the second main surface). The encapsulant may comprise a luminescent material. The luminescent material may be configured to convert at least part of the LED light. The encapsulant may also transmit at least part of the (unconverted) LED light. The encapsulant may comprise a resin, like a silicone, with the luminescent material embedded therein.

It appears that e.g. using a relatively blue-shifted garnet phosphor in combination with a relatively short wavelength broad-band red phosphor and a narrow-band red luminescent materials like quantum structure based luminescent materials, like quantum dots, or the Mn⁴⁺ based phosphor, an efficiency gain of at least 2.5% relative to existing systems may be provided.

Further optics may be comprised by the system, and may e.g. be configured downstream of the luminescent materials. The term "optics" may especially refer to (one or more) optical elements. Hence, the terms "optics" and "optical elements" may refer to the same items. The optics may include one or more or mirrors, reflectors, collimators, lenses, prisms, diffusers, phase plates, polarizers, diffractive elements, gratings, dichroics, arrays of one or more of the afore-mentioned, etc. Alternatively or additionally, the term "optics" may refer to a holographic element or a mixing rod. In embodiments, the optics may include one or more of beam expander optics and zoom lens optics. See further above for examples of optics. In embodiments, the optics may comprise an integrator, like a "Koehler integrator" (or "Köhler integrator").

In embodiments, the light generating system may be configured to generate white system light.

The term "white light", and similar terms, herein, is known to the person skilled in the art. It may especially relate to light having a correlated color temperature (CCT) between about 1800 K and 20000 K, such as between 2000 and 20000 K, especially 2700-20000 K, for general lighting especially in the range of about 2000-7000 K, such as in the range of 2700 K and 6500 K. In embodiments, e.g. for backlighting purposes, or for other purposes, the correlated color temperature (CCT) may especially be in the range of about 7000 K and 20000 K. Yet further, in embodiments the correlated color temperature (CCT) is especially within about 15 SDCM (standard deviation of color matching) from the BBL (black body locus), especially within about 10 SDCM from the BBL, even more especially within about 5 SDCM from the BBL. In specific embodiments, the correlated color temperature (CCT) may be selected from the range of 6000-12000 K, like selected from the range of 7000-12000 K, like at least 8000 K. Yet further, in embodiments the correlated color temperature (CCT) may be selected from the range of 6000-12000 K, like selected from the range of 7000-12000 K, in combination with a CRI of at least 70.

In the invention, the light generating device and the luminescent materials are selected such that the system light has a color rendering index selected from the range of at least 85, more especially at least 90, and a correlated color temperature selected from the range of 2000-8000 K, such as selected from the range of 2000-6500 K.

As indicated above, the light generating system may comprise one or more light generating devices. The one or more light generating devices may be controllable, such as the radiant flux may be controllable and/or in spectral power distribution of the device light may be controllable. Further, optionally the light generating system may comprise one or more second light generating devices, configured to generate second device light. In an operational mode, the system light may comprise such second device light. However, in other embodiments, the light generating system only comprises light generating devices configured to generate device light of which at least part is used by the luminescent materials to be converted into luminescent material light (i.e. first light generating devices). However, the system may also comprise two or more different types of first light generating devices, such as from different bins. In this way, the blue component in the system light may be controllable.

In specific embodiments, the system may comprise two or more arrangements of each one or more light generating devices and a first luminescent material, a second luminescent materials, and a third luminescent material, as described herein. One or more of such arrangements may be configured to generate primary light having a first correlated color temperature CCT1 and one or more other arrangements may be configured to generate secondary light having a second correlated color temperature CCT2, wherein CCT1 may differ from CCT2 (e.g. at least 500 K, see also below). Hence, the primary light and the secondary light may have different spectral power distributions (and may thus also have different correlated color temperatures). For instance, this may be achieved when different combinations of luminescent materials (selected from the first luminescent material, the second luminescent materials, and the third luminescent material) for the different arrangements. The system light may comprise in specific embodiments one or more of the primary light and the secondary light. In this way, the control system may (also) control the system light, by controlling the light generating devices of the two or more arrangements.

Hence, the system may further comprise a control system, configured to control the system light, such as its radiant flux and/or its spectral power distribution. Especially, this may be done by controlling the one of more light generating devices (and the optional second light generating device(s)).

The term "controlling" and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc.. Beyond that, the term "controlling" and similar terms may additionally include monitoring. Hence, the term "controlling" and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. In embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system may also be configured to receive and execute instructions from a remote control. In embodiments, the control system may be controlled via an App on a device, such as a portable device, like a Smartphone or I-phone, a tablet, etc.. The device is thus not necessarily coupled to the lighting system, but may be (temporarily) functionally coupled to the lighting system.

Hence, in embodiments the control system may (also) be configured to be controlled by an App on a remote device. In such embodiments the control system of the lighting system may be a slave control system or control in a slave mode. For instance, the lighting system may be identifiable with a code, especially a unique code for the respective lighting system. The control system of the lighting system may be configured to be controlled by an external control system which has access to the lighting system on the basis of knowledge (input by a user interface of with an optical sensor (e.g. QR code reader) of the (unique) code. The lighting system may also comprise means for communicating with other systems or devices, such as on the basis of Bluetooth, Thread, WIFI, LiFi, ZigBee, BLE or WiMAX, or another wireless technology.

The system, or apparatus, or device may execute an action in a "mode" or "operation mode" or "mode of operation" or "operational mode". The term "operational mode may also be indicated as "controlling mode". Likewise, in a method an action or stage, or step may be executed in a "mode" or "operation mode" or "mode of operation" or "operational mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, which can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

Hence, with such system, it may be possible to provide light having a controllable spectral power distribution. Further, with such system it may be possible to provide light having a controllable correlated color temperature and/or a controllable color rendering index. Yet, with such system it may be possible to provide a spectral power distribution partially or substantially conformal to the spectral power distribution (in the visible) of a black body radiator (emission). The fact that the light generating system may be configured to generate (white) system light, does not exclude embodiments of the system, wherein the system may also be able to operate or be operated in other operational modes. Especially, in embodiments the spectral power distribution of the system light may be controllable. Hence, in embodiments in a first operational mode (of the light generating system), the light generating system may be configured to generate the white system light and in a second operational mode (of the light generating system) the light generating system may be configured to generate non-white system light.

Therefore, in embodiments the light generating system may further comprise a control system configured to control a spectral power distribution of the system light. Especially, the control system may be configured to control the correlated color temperature of the system light at a value selected from the range of 1800-12000 K, such as selected from the range of 1800-6500 K, though other values are herein not excluded (see also above).

In specific embodiments, the correlated color temperature of the system light may be controllable over a CCT control range of at least 500 K within the range of 1800-12000 K, such as selected from the range of 1800-6500 K, such as controllable over a CCT control range of at least 1000 K. For instance, the CCT of the system light may be controllable between 2700-4000 K (i.e. over a CCT control range of 1300 K), or over a range of 2000-4500 K (i.e. over a CCT control range of 2500 K). Hence, in embodiments, the CCT (of the white system light) may be controlled from a first value CCT1 to a second value CCT2, wherein ICCT2-CCT1|≥500 K, more especially |CCT2-CCT1|≥1000 K.

The term "white light" herein, is known to the person skilled in the art. It especially relates to light having a correlated color temperature (CCT) between about 2000 and 20000 K, especially 2700-20000 K, for general lighting especially in the range of about 2700 K and 6500 K, and for backlighting purposes especially in the range of about 7000 K and 20000 K, and especially within about 15 SDCM (standard deviation of color matching) from the BBL (black body locus), especially within about 10 SDCM from the BBL, even more especially within about 5 SDCM from the BBL.

In embodiments, the system may comprise a light exit, like an end window or an (other) optical element, or an opening, from which the system light may escape to the external of the system. The system may comprise a housing, comprising such light exit. The housing may at least partly enclose the one or more light generating devices and the luminescent materials, and optionally one or more optical elements.

The light generating system may be part of or may be applied in e.g. office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, (outdoor) road lighting systems, urban lighting systems, green house lighting systems, horticulture lighting, digital projection, or LCD backlighting. The light generating system (or luminaire) may be part of or may be applied in e.g. optical communication systems or disinfection systems.

In yet a further aspect, the invention also provides a lamp or a luminaire comprising the light generating system as defined herein. The luminaire may further comprise a housing, optical elements, louvres, etc. etc... The lamp or luminaire may further comprise a housing enclosing the light generating system. The lamp or luminaire may comprise a light window in the housing or a housing opening, through which the system light may escape from the housing. In yet a further aspect, the invention also provides a projection device comprising the light generating system as defined herein. Especially, a projection device or "projector" or "image projector" may be an optical device that projects an image (or moving images) onto a surface, such as e.g. a projection screen. The projection device may include one or more light generating systems such as described herein. Hence, in an aspect the invention also provides a light generating device selected from the group of a lamp, a luminaire, a projector device, a disinfection device, a photochemical reactor, and an optical wireless communication device, comprising the light generating system as defined herein. The light generating device may comprise a housing or a carrier, configured to house or support, one or more elements of the light generating system (see also above). For instance, in embodiments the light generating device may comprise a housing or a carrier, configured to house or support one or more of the light generating device and the luminescent materials.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1c schematically depict some embodiments;
Figs. 2a-2b show some possible spectral power distributions;
Figs. 2c-2d show some further aspects; and
Fig. 3 schematically depict some applications. The schematic drawings are not necessarily to scale.

### DETAILED DESCRIPTION OF THE EMBODIMENTS

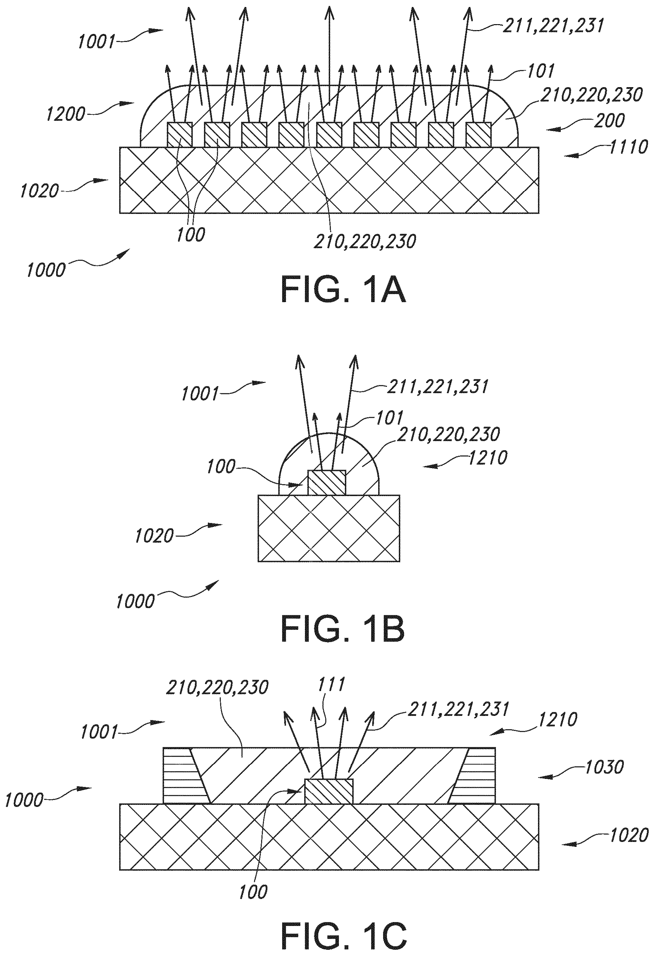

Referring to Figs. 1a-1c the invention provides in embodiments a light generating system 1000 comprising a light generating device 100, a first luminescent material 210, a second luminescent material 220, and a third luminescent material 230. The light generating device 100 is configured to generate device light 101 having a peak wavelength selected from the range of 435-475 nm. The light generating device 100 comprises a solid state light source. In embodiments, the light generating device 100 may comprise a light emitting diode. Reference 1020 refers to a support, such as a PCB.

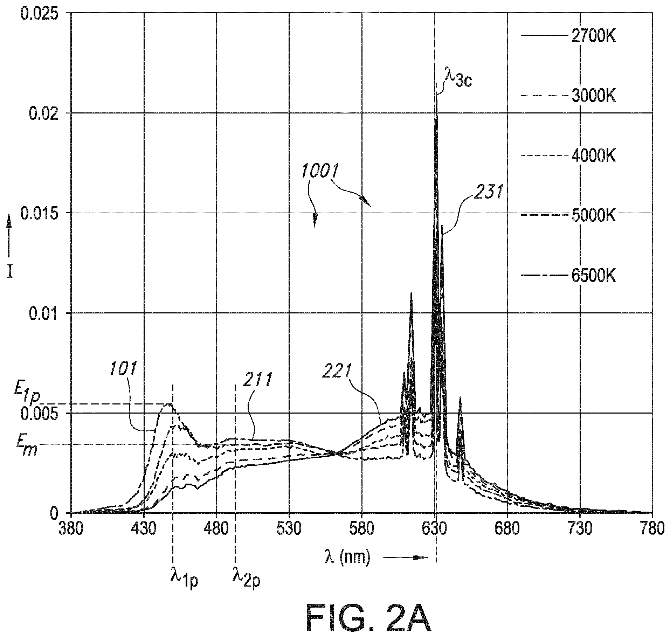

The first luminescent material 210 is configured to convert part of the device light 101 into first luminescent material light 211 having a color point with u' values selected from the range of 0.08-0.17 and v' values selected from the range of 0.5-0.57. The second luminescent material 220 is configured to convert part of the device light 101 into second luminescent material light 221 having a color point with u' values selected from the range of 0.32-0.4 and v' values selected from the range of 0.52-0.58. The third luminescent material 230 is configured to convert part of the device light 101 into third luminescent material light 231. The third luminescent material has a centroid wavelength (λ3c) selected from the range of 620-650 nm and a full width half maximum of 60 nm or smaller (see also Figs. 2a-2b).

The light generating system 1000 is configured to generate system light 1001 having a (system light) spectral power distribution comprising device light 101, first luminescent material light 211, second luminescent material light 221, and third luminescent material light 231.

Referring e.g. to Fig. 1a, the light generating system 1000 may comprise a chip-on-board light generating device 1110. The chip-on-board light generating device 1110 may comprise a plurality of light generating devices 100 and a luminescent layer 1200 configured downstream of the plurality of light generating devices 100. Especially, the luminescent layer 1200 may comprise the first luminescent material 210, the second luminescent material 220, and the third luminescent material 230.

Referring e.g. to Fig. 1b, the light generating system 1000 may comprise a dome-shaped body 1210 configured downstream of the light generating device 100. The dome-shaped body 1210 may comprise the first luminescent material 210, the second luminescent material 220, and the third luminescent material 230. In alternative embodiments, the luminescent materials 210,220,230 may be comprised by a layer between the light generating device 100 and at least part of the dome-shaped body 1210. In such embodiments, the dome-shaped body 1210 may not comprise luminescent materials.

Fig. 1c schematically depicts a light generating system 1000 comprising a reflector cup 1030, wherein the luminescent materials 210,220,230 are comprised in the reflector cup 1030. The luminescent materials 210,220,230 may be provided as such, but may also be encapsulated in a support material, such as a (silicone) resin.

In alternative embodiments, not depicted, the light generating system 1000 may comprise a filament.

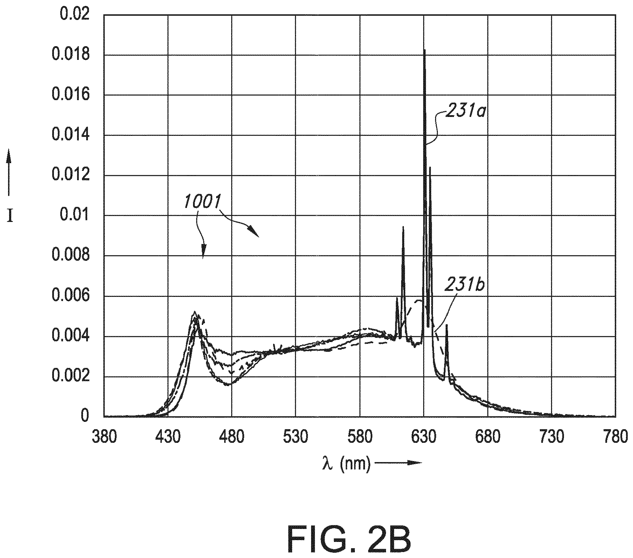

Referring also to Fig. 2a (and also effectively Fig. 2b) the (system light) spectral power distribution has a first spectral power (E₁ₚ) at a first peak maximum (λ1p) of the device light 101 and a second spectral power (Eₘ) at a minimum between the first peak maximum (λ1p) of the device light 101 and a second peak maximum (λ2p) of the first luminescent material light 211. Especially, the light generating device 100 and the luminescent materials 210,220,230,... are selected such that 1.0≤E₁ₚ/Eₘ≤2.5. In embodiments, the light generating device 100 and the luminescent materials 210,220,230 are selected such that 1.0≤E₁ₚ/Eₘ≤2.0 when the system light 1001 has a correlated color temperature of at maximum 5000 K, and selected such that 1.0≤E₁ₚ/Eₘ≤2.5, more especially 1.5≤E₁ₚ/Eₘ≤2.5, when the system light 1001 has a correlated color temperature above 5000 K.

In specific embodiments, the third luminescent material 230 may be configured to convert part of the device light 101 into third luminescent material light 231 having a color point with u' values selected from the range of 0.46-0.61 and v' values selected from the range of 0.50-0.53.

In specific embodiments, the third luminescent material 230 may comprise a luminescent material of the type M'ₓM₂₋₂ₓAX₆ doped with tetravalent manganese, M' may comprise an alkaline earth cation, M may comprise an alkaline cation, and x may be in the range of 0-1, A may comprise a tetravalent cation, comprising one or more of silicon and titanium, and X may comprise a monovalent anion, at least comprising fluorine.

The term "the luminescent materials" or the indication "210,220,230,..." may in embodiments especially refer to the combination of the first luminescent material, the second luminescent material, the third luminescent material, and optionally further luminescent materials. In specific embodiments, all luminescent materials comprised by the system are selected from the first luminescent material, the second luminescent material, and the third luminescent material.

In embodiments, the third luminescent material 230 may comprise (K,Rb)₂SiF₆:Mn⁴⁺ and/or K₂SiF₆:Mn⁴⁺ and/or K₂TiF₆:Mn⁴⁺. Alternatively or additionally, in embodiments the third luminescent material 230 may comprise a quantum structure based luminescent material. For instance, the third luminescent material 230 may comprise quantum dots.

Referring to Figs. 2a-2b all spectral power distributions have a CRI of at least 80 (or even at least about 90). In Fig. 2b, reference 231a refers to the emission of a Mn-based luminescent material and reference 231b refers to the emission of a quantum structure based luminescent material. Referring to Figs. 2a-2b, the first luminescent material light 211 and the second luminescent material light 221 may have full width half maximum in the spectral power distribution of the system light 1001 of at least 70 nm. Both Figures show spectral power distributions ranging from 2700-6500 K, based on the same light generating device and luminescent materials 210,220,230. In addition, Fig. 2b also shows an embodiment wherein the third luminescent material comprises a quantum structure based luminescent material.

In embodiments, the first luminescent material 210 may comprise a luminescent material of the type A₃B₅O₁₂:Ce, A may comprise one or more of Y, La, Gd, Tb and Lu, and B may comprise one or more of Al, Ga, In and Sc. Especially, A may comprise Lu and/or B may comprise Ga.

In specific embodiments, the second luminescent material 220 may comprise a luminescent material of the type MAlSiN₃:Eu, M may be one or more elements selected from the group consisting of Ba, Sr, and Ca. Especially, M may comprise Sr. However, M may also comprise Ca. In specific embodiments, M may comprise Ca and Sr.

In embodiments, the device light 101 may have a peak wavelength selected from the range of 445-465 nm.

In specific embodiments, the light generating device 100 and the luminescent materials may be selected such that the system light 1001 has a color rendering index selected from the range of at least 90, and a correlated color temperature selected from the range of 2000-8000 K.

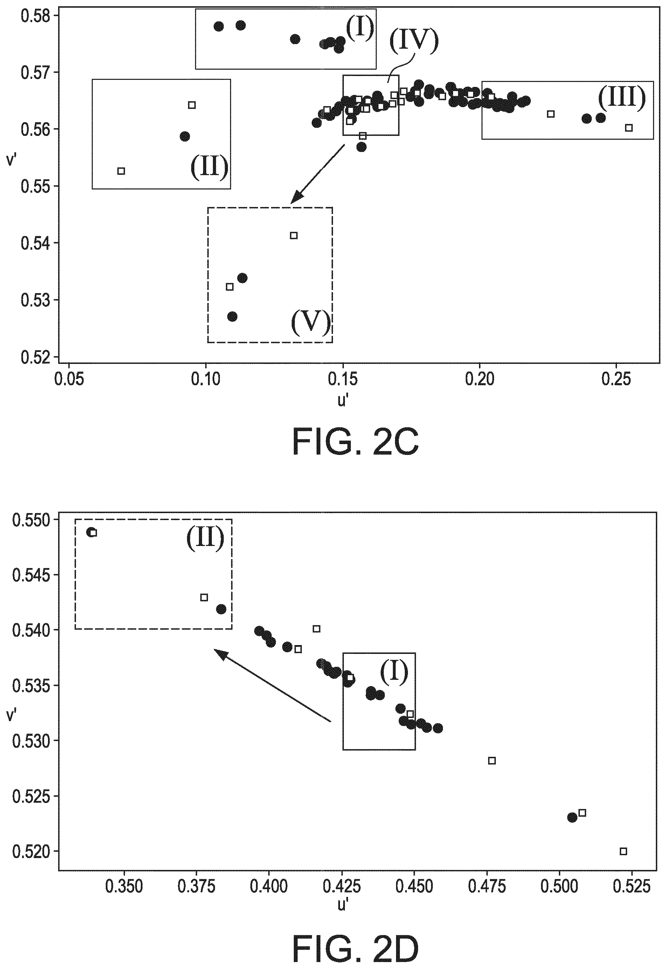

To find the most optimal solution, simulations with a wide range of yellow/green phosphors 210 (see Fig 2c, which gives the phosphor CIE u',v' color points), combined with a wide range of broad red phosphors 220 (see Fig 2d, which gives the phosphor CIE u',v' color points) and Mn-based or QD-based luminescent materials 230 (in various amounts). This modeling is based on both measured and simulated absorption and emission spectra and taking into account phosphor interactions. The target color points for this optimization were chosen as 2700, 3000, 3500, 4000, 5000 and 6500K, on the BBL. The resulting efficiency (CE=conversion efficiency, Lm/Wₒₚₜ) at 3500K (as an example) were determined. A possible solution uses a yellow/green garnet phosphor (Fig. 2c) selected from 0.14<u'<0.24 and 0.55<v'<0.57) and has a maximum efficiency of 260 Lm/_{Wopt}.

However, surprisingly even more efficient solutions have been found. The more efficient solutions use e.g. a blue-shifted garnet phosphor with 0.10<u'<0.15 and 0.52<v'<0.55 (Fig. 2c) in combination with a red phosphor with e.g. 0.34<u'<0.38 and 0.54<v'<0.56 (Fig. 2d).

Fig. 2c shows an overview of yellow/green phosphor color points. Box V shows amongst others color points of herein described first luminescent materials. Fig. 2d shows an overview of the broad red phosphor color points. Box II shows amongst others color points of herein described second luminescent materials.

The herein proposed solutions may provide an efficiency gain between 2.5 and 7.5% relative to existing solutions, while maintaining high CRI's and providing a decreased cyan gap.

The indication luminescent materials 210,220,230 does not exclude that other luminescent materials may be available. The indication "luminescent materials 210,220,230...", and similar indications, may indicate the luminescent materials 210,220,230 and optionally one or more further luminescent materials.

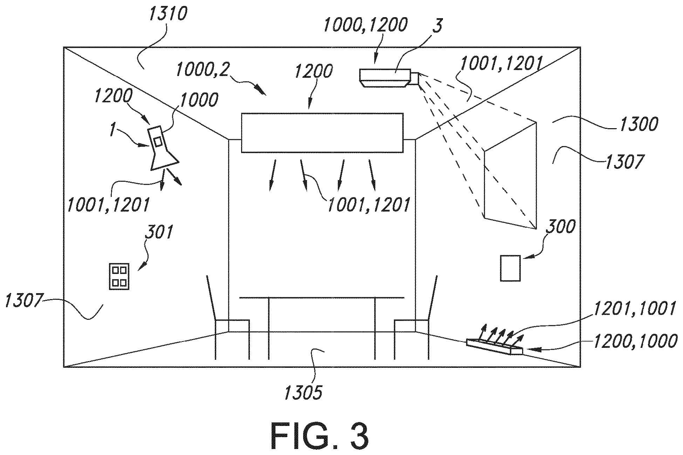

Fig. 3 schematically depicts an embodiment of a luminaire 2 comprising the light generating system 1000 as described above. Reference 301 indicates a user interface which may be functionally coupled with the control system 300 comprised by or functionally coupled to the light generating system 1000. Fig. 3 also schematically depicts an embodiment of lamp 1 comprising the light generating system 1000. Reference 3 indicates a projector device or projector system, which may be used to project images, such as at a wall, which may also comprise the light generating system 1000. Hence, Fig. 3 schematically depicts embodiments of a lighting device 1200 selected from the group of a lamp 1, a luminaire 2, a projector device 3, a disinfection device, a photochemical reactor, and an optical wireless communication device, comprising the light generating system 1000 as described herein. In embodiments, such lighting device may be a lamp 1, a luminaire 2, a projector device 3, a disinfection device, or an optical wireless communication device. Lighting device light escaping from the lighting device 1200 is indicated with reference 1201. Lighting device light 1201 may essentially consist of system light 1001, and may in specific embodiments thus be system light 1001. Reference 1300 refers to a space, such as a room.

The term "plurality" refers to two or more.

The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%.

The term "comprise" also includes embodiments wherein the term "comprises" means "consists of".

The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to".

The article "a" or "an" preceding an element does not exclude the presence of a plurality of such elements.

The invention is defined by the appended claims.

## Claims

1. A light generating system (1000) comprising a light generating device (100), a first luminescent material (210), a second luminescent material (220), and a third luminescent material (230), wherein:
- the light generating device (100) is configured to generate device light (101) having a peak wavelength selected from the range of 435-475 nm; wherein the light generating device (100) comprises a solid state light source;
- the first luminescent material (210) is configured to convert part of the device light (101) into first luminescent material light (211) having a color point with u' values selected from the range of 0.08-0.17 and v' values selected from the range of 0.50-0.57;
- the second luminescent material (220) is configured to convert part of the device light (101) into second luminescent material light (221) having a color point with u' values selected from the range of 0.32-0.40 and v' values selected from the range of 0.52-0.58;
- the third luminescent material (230) is configured to convert part of the device light (101) into third luminescent material light (231); wherein the third luminescent material light has a centroid wavelength (λ3c) selected from the range of 620-650 nm and a full width half maximum of 60 nm or smaller;
- the light generating system (1000) is configured to generate system light (1001) having a spectral power distribution comprising device light (101), first luminescent material light (211), second luminescent material light (221), and third luminescent material light (231); wherein the spectral power distribution has a first spectral power (E₁ₚ) at a first peak maximum (λ1p) of the device light (101) and a second spectral power (Eₘ) at a minimum between the first peak maximum (λ1p) of the device light (101) and a second peak maximum (λ2p) of the first luminescent material light (211);
- the light generating device (100) and the luminescent materials (210,220,230,...) are selected such that 1.0 ≤ E₁ₚ/Eₘ ≤ 2.5; and
- the light generating device (100) and the luminescent materials (210,220,230,...) are selected such that the system light (1001) has a color rendering index
selected from the range of at least 85, and a correlated color temperature selected from the range of 2000-8000 K.

2. The light generating system (1000) according to claim 1, wherein the third luminescent material (230) is configured to convert part of the device light (101) into third luminescent material light (231) having a color point with u' values selected from the range of 0.46-0.61 and v' values selected from the range of 0.50-0.53, wherein the first luminescent material light (211) has a color point with u' values selected from the range of 0.10-0.15 and v' values selected from the range of 0.52-0.55; and wherein the second luminescent material light (221) has a color point with u' values selected from the range of 0.33-0.38 and v' values selected from the range of 0.54-0.56.

3. The light generating system (1000) according to any one of the preceding claims, wherein the third luminescent material (230) comprises a luminescent material of the type M'ₓM₂₋₂ₓAX₆ doped with tetravalent manganese, wherein M' comprises an alkaline earth cation, M comprises an alkaline cation, and x is in the range of 0-1, wherein A comprises a tetravalent cation, comprising one or more of silicon and titanium, wherein X comprises a monovalent anion, at least comprising fluorine.

4. The light generating system (1000) according to any one of the preceding claims, wherein the third luminescent material (230) comprises K₂SiF₆:Mn⁴⁺.

5. The light generating system (1000) according to any one of the preceding claims, wherein the third luminescent material (230) comprises a quantum structure based luminescent material.

6. The light generating system (1000) according to any one of the preceding claims, wherein both the first luminescent material light (211) and the second luminescent material light (221) have full width half maximum in the spectral power distribution of the system light (1001) of at least 70 nm.

7. The light generating system (1000) according to any one of the preceding claims, wherein the first luminescent material (210) comprises a luminescent material of the type A₃B₅O₁₂:Ce³⁺ , wherein A comprises one or more of Y, La, Gd, Tb and Lu, and wherein B comprises one or more of Al, Ga, In and Sc.

8. The light generating system (1000) according to claim 7, wherein A comprises Lu and/or wherein B comprises Ga.

9. The light generating system (1000) according to any one of the preceding claims, wherein the second luminescent material (220) comprises a luminescent material of the type MAlSiN₃:Eu, wherein M is one or more elements selected from the group consisting of Ba, Sr, and Ca.

10. The light generating system (1000) according to claim 9, wherein M comprises Sr and Ca.

11. The light generating system (1000) according to any one of the preceding claims, wherein the light generating device (100) and the luminescent materials (210,220,230,...) are selected such that 1.0 ≤ E₁ₚ/Eₘ ≤ 2.0 when the system light (1001) has a correlated color temperature of at maximum 5000 K, and selected such that 1.0≤E₁ₚ/Eₘ≤2.5, when the system light (1001) has a correlated color temperature above 5000 K; wherein the device light (101) has a peak wavelength selected from the range of 445-465 nm; and wherein the light generating device (100) comprises a light emitting diode.

12. The light generating system (1000) according to any one of the preceding claims 1-11, comprising a plurality of light generating devices (100) and a luminescent layer (1200) configured downstream of the plurality of light generating devices (100), wherein the luminescent layer (1200) comprises the first luminescent material (210), the second luminescent material (220), and the third luminescent material (230).

13. The light generating system (1000) according to any one of the preceding claims 1-11, comprising a dome-shaped body (1210) configured downstream of the light generating device (100), wherein the dome-shaped body (1210) comprises the first luminescent material (210), the second luminescent material (220), and the third luminescent material (230).

14. The light generating system (1000) according to any one of the preceding claims, wherein the light generating device (100) and the luminescent materials (210,220,230,...) are selected such that the system light (1001) has a color rendering index selected from the range of at least 90, and a correlated color temperature selected from the range of 2000-6500 K.

15. A lighting device (1200) selected from the group of a lamp (1) and a luminaire (2), comprising the light generating system (1000) according to any one of claims 1-14.

## Patentansprüche

1. Lichterzeugungssystem (1000), umfassend eine Lichterzeugungsvorrichtung (100), einen ersten Leuchtstoff (210), einen zweiten Leuchtstoff (220) und einen dritten Leuchtstoff (230), wobei:
- die Lichterzeugungsvorrichtung (100) konfiguriert ist, um Vorrichtungslicht (101) zu erzeugen, das eine Spitzenwellenlänge aufweist, die aus dem Bereich von 435-475 nm ausgewählt ist; wobei die Lichterzeugungsvorrichtung (100) eine Festkörperlichtquelle umfasst;
- der erste Leuchtstoff (210) konfiguriert ist, um einen Teil des Vorrichtungslichts (101) in Licht (211) des ersten Leuchtstoffs umzuwandeln, das einen Farbpunkt mit u'-Werten, die aus dem Bereich von 0,08-0,17 ausgewählt sind, und v'-Werten aufweist, die aus dem Bereich von 0,50-0,57 ausgewählt sind;
- der zweite Leuchtstoff (220) konfiguriert ist, um einen Teil des Vorrichtungslichts (101) in Licht (221) des zweiten Leuchtstoffs umzuwandeln, das einen Farbpunkt mit u'-Werten, die aus dem Bereich von 0,32-0,40 ausgewählt sind, und v'-Werten aufweist, die aus dem Bereich von 0,52-0,58 ausgewählt sind;
- der dritte Leuchtstoff (230) konfiguriert ist, um einen Teil des Vorrichtungslichts (101) in Licht (231) des dritten Leuchtstoffs umzuwandeln; wobei das Licht des dritten Leuchtstoffs eine Schwerpunktwellenlänge (λ3c), die aus dem Bereich von 620-650 nm ausgewählt ist, und eine Halbwertsbreite von 60 nm oder kleiner aufweist;
- das Lichterzeugungssystem (1000) konfiguriert ist, um Systemlicht (1001) zu erzeugen, das eine spektrale Leistungsverteilung aufweist, umfassend Vorrichtungslicht (101), Licht (211) des ersten Leuchtstoffs, Licht (221) des zweiten Leuchtstoffs und Licht (231) des dritten Leuchtstoffs; wobei die spektrale Leistungsverteilung eine erste spektrale Leistung (E₁ₚ) bei einem ersten Spitzenmaximum (λ1p) des Vorrichtungslichts (101) und eine zweite spektrale Leistung (Eₘ) bei einem Minimum zwischen dem ersten Spitzenmaximum (λ1p) des Vorrichtungslichts (101) und einem zweiten Spitzenmaximum (λ2p) des Lichts (211) des ersten Leuchtstoffs aufweist;
- die Lichterzeugungsvorrichtung (100) und die Leuchtstoffe (210, 220, 230, ...) derart ausgewählt sind, dass 1,0 ≤ E₁ₚ/Eₘ ≤ 2,5; und
- die Lichterzeugungsvorrichtung (100) und die Leuchtstoffe (210, 220, 230, ...) derart ausgewählt sind, dass das Systemlicht (1001) einen Farbwiedergabeindex, der aus dem Bereich von mindestens 85 ausgewählt ist, und eine korrelierte Farbtemperatur aufweist, die aus dem Bereich von 2000-8000 K ausgewählt ist.

2. Lichterzeugungssystem (1000) nach Anspruch 1, wobei der dritte Leuchtstoff (230) konfiguriert ist, um einen Teil des Vorrichtungslichts (101) in Licht (231) des dritten Leuchtstoffs umzuwandeln, das einen Farbpunkt mit u'-Werten, die aus dem Bereich von 0,46-0,61 ausgewählt sind, und v'-Werten aufweist, die aus dem Bereich von 0,50-0,53 ausgewählt sind, wobei das Licht (211) des ersten Leuchtstoffs einen Farbpunkt mit u'-Werten, die aus dem Bereich von 0,10-0,15 ausgewählt sind, und v'-Werten aufweist, die aus dem Bereich von 0,52-0,55 ausgewählt sind; und wobei das Licht (221) des zweiten Leuchtstoffs einen Farbpunkt mit u'- Werten, die aus dem Bereich von 0,33-0,38 ausgewählt sind, und v'-Werten aufweist, die aus dem Bereich von 0,54-0,56 ausgewählt sind.

3. Lichterzeugungssystem (1000) nach einem der vorstehenden Ansprüche, wobei der dritte Leuchtstoff (230) einen Leuchtstoff der Art M'ₓM₂₋₂ₓAX₆ umfasst, der mit tetravalentem Mangan dotiert ist, wobei M' ein Erdalkalikation umfasst, M ein Alkalikation umfasst, und x im Bereich von 0-1 liegt, wobei A ein tetravalentes Kation umfasst, umfassend eines oder mehrere von Silizium und Titan, wobei X ein monovalentes Anion umfasst, umfassend mindestens Fluor.

4. Lichterzeugungssystem (1000) nach einem der vorstehenden Ansprüche, wobei der dritte Leuchtstoff (230) K₂SiF₆:Mn⁴⁺ umfasst.

5. Lichterzeugungssystem (1000) nach einem der vorstehenden Ansprüche, wobei der dritte Leuchtstoff (230) einen Leuchtstoff umfasst, der auf Quantenstruktur basiert.

6. Lichterzeugungssystem (1000) nach einem der vorstehenden Ansprüche, wobei sowohl das Licht (211) des ersten Leuchtstoffs als auch das Licht (221) des zweiten Leuchtstoffs eine Halbwertsbreite in der spektralen Leistungsverteilung des Systemlichts (1001) von mindestens 70 nm aufweisen.

7. Lichterzeugungssystem (1000) nach einem der vorstehenden Ansprüche, wobei der erste Leuchtstoff (210) einen Leuchtstoff der Art A₃B₅O₁₂:Ce³⁺ umfasst, wobei A eines oder mehrere von Y, La, Gd, Tb und Lu umfasst, und wobei B eines oder mehrere von Al, Ga, In und Sc umfasst.

8. Lichterzeugungssystem (1000) nach Anspruch 7, wobei A Lu umfasst und/oder wobei B Ga umfasst.

9. Lichterzeugungssystem (1000) nach einem der vorstehenden Ansprüche, wobei der zweite Leuchtstoff (220) einen Leuchtstoff der Art MAlSiN₃:Eu umfasst, wobei M ein oder mehrere Elemente ist, die aus der Gruppe ausgewählt sind, bestehend aus Ba, Sr und Ca.

10. Lichterzeugungssystem (1000) nach Anspruch 9, wobei M Sr und Ca umfasst.

11. Lichterzeugungssystem (1000) nach einem der vorstehenden Ansprüche, wobei die Lichterzeugungsvorrichtung (100) und die Leuchtstoffe (210, 220, 230, ...) derart ausgewählt sind, dass 1,0 ≤ E₁ₚ/Eₘ ≤ 2,0, wenn das Systemlicht (1001) eine korrelierte Farbtemperatur von höchstens 5000 K aufweist, und derart ausgewählt sind, dass 1,0 ≤ E₁ₚ/Eₘ ≤ 2,5, wenn das Systemlicht (1001) eine korrelierte Farbtemperatur über 5000 K aufweist; wobei das Vorrichtungslicht (101) eine Spitzenwellenlänge aufweist, die aus dem Bereich von 445-465 nm ausgewählt ist; und wobei die Lichterzeugungsvorrichtung (100) eine lichtemittierende Diode umfasst.

12. Lichterzeugungssystem (1000) nach einem der vorstehenden Ansprüche 1 bis 11, umfassend eine Vielzahl von Lichterzeugungsvorrichtungen (100) und eine lumineszierende Schicht (1200), die stromabwärts der Vielzahl von Lichterzeugungsvorrichtungen (100) konfiguriert ist, wobei die lumineszierende Schicht (1200) den ersten Leuchtstoff (210), den zweiten Leuchtstoff (220) und den dritten Leuchtstoff (230) umfasst.

13. Lichterzeugungssystem (1000) nach einem der vorstehenden Ansprüche 1 bis 11, umfassend einen kuppelförmigen Körper (1210), der stromabwärts der Lichterzeugungsvorrichtung (100) konfiguriert ist, wobei der kuppelförmige Körper (1210) den ersten Leuchtstoff (210), den zweiten Leuchtstoff(220) und den dritten Leuchtstoff (230) umfasst.

14. Lichterzeugungssystem (1000) nach einem der vorstehenden Ansprüche, wobei die Lichterzeugungsvorrichtung (100) und die Leuchtstoffe (210, 220, 230, ...) derart ausgewählt sind, dass das Systemlicht (1001) einen Farbwiedergabeindex, der aus dem Bereich von mindestens 90 ausgewählt ist, und eine korrelierte Farbtemperatur aufweist, die aus dem Bereich von 2000-6500 K ausgewählt ist.

15. Beleuchtungsvorrichtung (1200), die aus der Gruppe einer Lampe (1) und einer Leuchte (2) ausgewählt ist, umfassend das Lichterzeugungssystem (1000) nach einem der Ansprüche 1 bis 14.

## Revendications

1. Système générateur de lumière (1000) comprenant un dispositif générateur de lumière (100), un premier matériau luminescent (210), un deuxième matériau luminescent (220) et un troisième matériau luminescent (230), dans lequel :
- le dispositif générateur de lumière (100) est configuré pour générer de la lumière de dispositif (101) ayant une longueur d'onde de pic sélectionnée dans la plage de 435 à 475 nm ; dans lequel le dispositif générateur de lumière (100) comprend une source de lumière à semi-conducteurs ;
- le premier matériau luminescent (210) est configuré pour convertir une partie de la lumière de dispositif (101) en lumière de premier matériau luminescent (211) ayant un point de couleur avec des valeurs u' sélectionnées dans la plage de 0,08 à 0,17 et des valeurs v' sélectionnées dans la plage de 0,50 à 0,57 ;
- le deuxième matériau luminescent (220) est configuré pour convertir une partie de la lumière de dispositif (101) en lumière de deuxième matériau luminescent (221) ayant un point de couleur avec des valeurs u' sélectionnées dans la plage de 0,32 à 0,40 et des valeurs v' sélectionnées dans la plage de 0,52 à 0,58 ;
- le troisième matériau luminescent (230) est configuré pour convertir une partie de la lumière de dispositif (101) en lumière de troisième matériau luminescent (231) ; dans lequel la lumière de troisième matériau luminescent a une longueur d'onde centroïde (λ3c) sélectionnée dans la plage de 620 à 650 nm et une largeur totale à mi-hauteur de 60 nm ou plus petite ;
- le système générateur de lumière (1000) est configuré pour générer de la lumière de système (1001) ayant une distribution de puissance spectrale comprenant de la lumière de dispositif (101), de la lumière de premier matériau luminescent (211), de la lumière de deuxième matériau luminescent (221) et de la lumière de troisième matériau luminescent (231) ; dans lequel la distribution de puissance spectrale a une première puissance spectrale (E₁ₚ) au niveau d'un premier maximum de pic (λ1p) de la lumière de dispositif (101) et une seconde puissance spectrale (Eₘ) au niveau d'un minimum entre le premier maximum de pic (λ1p) de la lumière de dispositif (101) et un second maximum de pic (λ2p) de la lumière de premier matériau luminescent (211) ;
- le dispositif générateur de lumière (100) et les matériaux luminescents (210, 220, 230,...) sont sélectionnés de telle sorte que 1,0 ≤ E₁ₚ/Eₘ ≤ 2,5 ; et
- le dispositif générateur de lumière (100) et les matériaux luminescents (210, 220, 230,...) sont sélectionnés de telle sorte que la lumière de système (1001) a un indice de restitution de couleurs sélectionné dans la plage d'au moins 85, et une température de couleur corrélée sélectionnée dans la plage de 2000 à 8000 K.

2. Système générateur de lumière (1000) selon la revendication 1, dans lequel le troisième matériau luminescent (230) est configuré pour convertir une partie de la lumière de dispositif (101) en lumière de troisième matériau luminescent (231) ayant un point de couleur avec des valeurs u' sélectionnées dans la plage de 0,46 à 0,61 et des valeurs v' sélectionnées dans la plage de 0,50 à 0,53, dans lequel la lumière de premier matériau luminescent (211) a un point de couleur avec des valeurs u' sélectionnées dans la plage de 0,10 à 0,15 et des valeurs v' sélectionnées dans la plage de 0,52 à 0,55 ; et dans lequel la lumière de deuxième matériau luminescent (221) a un point de couleur avec des valeurs u' sélectionnées dans la plage de 0,33 à 0,38 et des valeurs v' sélectionnées dans la plage de 0,54 à 0,56.

3. Système générateur de lumière (1000) selon l'une quelconque des revendications précédentes, dans lequel le troisième matériau luminescent (230) comprend un matériau luminescent du type M'ₓM₂₋₂ₓAX₆ dopé avec du manganèse tétravalent, dans lequel M' comprend un cation alcalino-terreux, M comprend un cation alcalin, et x est dans la plage de 0 à 1, dans lequel A comprend un cation tétravalent, comprenant un ou plusieurs parmi silicium et titane, dans lequel X comprend un anion monovalent, comprenant au moins du fluor.

4. Système générateur de lumière (1000) selon l'une quelconque des revendications précédentes, dans lequel le troisième matériau luminescent (230) comprend K₂SiF₆:Mn⁴⁺.

5. Système générateur de lumière (1000) selon l'une quelconque des revendications précédentes, dans lequel le troisième matériau luminescent (230) comprend un matériau luminescent à base de structure quantique.

6. Système générateur de lumière (1000) selon l'une quelconque des revendications précédentes, dans lequel tant la lumière de premier matériau luminescent (211) que la lumière de deuxième matériau luminescent (221) ont une largeur totale à mi-hauteur dans la distribution de puissance spectrale de la lumière de système (1001) d'au moins 70 nm.

7. Système générateur de lumière (1000) selon l'une quelconque des revendications précédentes, dans lequel le premier matériau luminescent (210) comprend un matériau luminescent du type A₃B₅O₁₂:Ce³⁺, dans lequel A comprend un ou plusieurs parmi Y, La, Gd, Tb et Lu, et dans lequel B comprend un ou plusieurs parmi AI, Ga, In et Sc.

8. Système générateur de lumière (1000) selon la revendication 7, dans lequel A comprend Lu et/ou dans lequel B comprend Ga.

9. Système générateur de lumière (1000) selon l'une quelconque des revendications précédentes, dans lequel le deuxième matériau luminescent (220) comprend un matériau luminescent du type MAISiN₃:Eu, dans lequel M est un ou plusieurs éléments sélectionnés dans le groupe constitué de Ba, Sr et Ca.

10. Système générateur de lumière (1000) selon la revendication 9, dans lequel M comprend Sr et Ca.

11. Système générateur de lumière (1000) selon l'une quelconque des revendications précédentes, dans lequel le dispositif générateur de lumière (100) et les matériaux luminescents (210, 220, 230,...) sont sélectionnés de telle sorte que 1,0 ≤ E₁ₚ/Eₘ ≤ 2,0 lorsque la lumière de système (1001) a une température de couleur corrélée d'au maximum 5000 K, et sélectionnés de telle sorte que 1,0 ≤ E₁ₚ/Eₘ ≤ 2,5, lorsque la lumière de système (1001) a une température de couleur corrélée supérieure à 5000 K ; dans lequel la lumière de dispositif (101) a une longueur d'onde de pic sélectionnée dans la plage de 445 à 465 nm ; et dans lequel le dispositif générateur de lumière (100) comprend une diode électroluminescente.

12. Système générateur de lumière (1000) selon l'une quelconque des revendications 1 à 11 précédentes, comprenant une pluralité de dispositifs générateurs de lumière (100) et une couche luminescente (1200) configurée en aval de la pluralité de dispositifs générateurs de lumière (100), dans lequel la couche luminescente (1200) comprend le premier matériau luminescent (210), le deuxième matériau luminescent (220) et le troisième matériau luminescent (230).

13. Système générateur de lumière (1000) selon l'une quelconque des revendications 1 à 11 précédentes, comprenant un corps en forme de dôme (1210) configuré en aval du dispositif générateur de lumière (100), dans lequel le corps en forme de dôme (1210) comprend le premier matériau luminescent (210), le deuxième matériau luminescent (220) et le troisième matériau luminescent (230).

14. Système générateur de lumière (1000) selon l'une quelconque des revendications précédentes, dans lequel le dispositif générateur de lumière (100) et les matériaux luminescents (210, 220, 230,...) sont sélectionnés de telle sorte que la lumière de système (1001) a un indice de restitution de couleurs sélectionné dans la plage d'au moins 90, et une température de couleur corrélée sélectionnée dans la plage de 2000 à 6500 K.

15. Dispositif d'éclairage (1200) sélectionné dans le groupe d'une lampe (1) et d'un luminaire (2), comprenant le système générateur de lumière (1000) selon l'une quelconque des revendications 1 à 14.
